# EUROPEAN PATENT APPLICATION

(11) **EP 4 641 871 A1**
(43) Date of publication of application: **29.10.2025**
(21) Application number: 25172415.9
(22) Date of filing: 24.04.2025
(51) Int. Cl.: H02J 5/00, G06F 1/18, H02J 1/08

(54) **MEDIUM AND LOW VOLTAGE POWER CENTER**

(30) Priority: 26.04.2024 US 202463639087 P; 31.03.2025 US 202519095367
(71) Applicant: Vertiv Corporation, Westerville, OH 43082 (US)
(72) Inventor: PANFIL, Peter A., Westerville (US); EASTERDAY, Timothy K., Westerville (US)
(74) Representative: Beal, James Michael

(57) **Abstract**

A power system may include a power center (200). The power center may include a busway flange (208) configured to receive the input AC voltage from a first busway (206). The power center may include an AC converter (210) configured to receive the input AC voltage from the busway flange and convert the input AC voltage to at least one of a secondary AC voltage or the output DC voltage. The power center may include a battery (106) configured to store the output DC voltage and release an output DC voltage to a second busway. The AC converter may include a solid-state transformer.

## Description

### CROSS-REFERENCE TO RELATED APPLICATIONS

The present application claims priority to U.S. Provisional Patent Application Number 63/639,087, filed April 26, 2024, and to U.S. Non-Provisional Patent Application Number 19/095,367, filed March 20, 2025.

### TECHNICAL FIELD

The present disclosure relates to power systems for electronic equipment, and more particularly to power systems for servers and server racks.

### BACKGROUND

Data centers are high power-use environments requiring large inputs of electricity to operate high numbers of servers within a small space, such as a server rack. Delivering power to the server rack traditionally required several conversion steps from utility power to the chip. For example, data centers often convert incoming alternating current (AC) power to direct current (DC) power for storage, such as in an uninterruptable power source (UPS) or battery. When power from the UPS or battery is needed, the power is converted from DC power to AC power and distributed throughout the server rack via power distribution units (PDU). Once distributed to the individual server, the AC power is again converted to DC power for use. This power distribution method from utility AC power to server DC power results in considerable power losses due to energy loss at each conversion step and increases in conversion-generated heat. The method also requires the use of extensive cabling that increases the complexity of design and increases design footprint.

Accordingly, it may be advantageous to have a power conversion and distribution system without the aforementioned cost and labor inputs.

### SUMMARY

Accordingly, the present disclosure is directed toward systems and methods for converting an input alternating current (AC) voltage to an output direct current (DC) voltage and distributing the output DC voltage.

In one or more embodiments, the techniques described herein relate to a power system. In one embodiment, the power system includes a power center configured to convert an input alternating current (AC) voltage to an output direct current (DC) voltage. In another embodiment, the power center includes a busway flange configured to receive the input AC voltage from a first busway. In another embodiment, the power center includes an AC converter configured to receive the input AC voltage from the busway flange and convert the input AC voltage into an output DC voltage. In another embodiment, the power center includes a battery configured to store DC power; and release the output DC voltage to a second busway.

In embodiments, the techniques described herein relate to another power system. In one or more embodiments, the power system includes a power center configured to convert an input alternating current (AC) voltage to an output direct current (DC) voltage. In one or more embodiments, the power center includes a tap off box configured to receive the input AC voltage from a first busway. In another embodiment, the power center includes an AC converter configured to receive the input AC voltage from the tap off box and convert the AC voltage into the output direct current (DC) voltage. In another embodiment, the power center includes a battery configured to store the DC voltage; and release an output DC voltage to a plurality of servers.

In embodiments, the techniques described herein relate to a method for powering a server rack. In one embodiment, the method includes receiving utility power, wherein receiving utility power includes receiving an input alternating current (AC) voltage; converting the input alternative current into an output DC voltage. In another embodiment, the method includes storing the output DC voltage as a stored energy. In another embodiment, the method includes releasing the stored energy as the output DC voltage to a server rack. In another embodiment, the method includes consuming the output DC voltage by the server rack, wherein the output DC voltage is not converted into an AC voltage between releasing the stored energy and consuming the output DC voltage.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF DRAWINGS

The numerous advantages of the disclosure may be better understood by those skilled in the art by reference to the accompanying figures.
FIG. 1 illustrates a block diagram depicting a power system scheme for powering a server rack, in accordance with one or more embodiments of the disclosure.
FIG. 2A illustrates a block diagram depicting a power system, in accordance with one or more embodiments of the disclosure.
FIG. 2B illustrates a block diagram depicting a view of a power system that includes a second busway, in accordance with one or more embodiments of the disclosure.
FIG. 3 illustrates a block diagram depicting another power system, in accordance with one or more embodiments of the disclosure.
FIG. 4 illustrates a block diagram depicting the power systems, in accordance with one or more embodiments of the present disclosure.
FIG. 5 illustrates a process flow diagram depicting a method for powering a server rack, in accordance with one or more embodiments of the disclosure.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, the use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "embodiments" means that a particular element, feature, structure, or characteristic described in connection with the embodiment is included in at least one embodiment disclosed herein. The appearances of the phrase "in embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Disclosed is a power system that provides power conversion for a plurality of electronic devices, such as a plurality of servers, or a server rack. The power system includes a power center, or substation, which converts an input alternating current (AC) voltage, such as utility input AC voltage, into an output direct current (DC) voltage. The output DC voltage is then distributed to the plurality of servers without any intermediate DC to AC conversion step (e.g., no AC power coming from a UPS or a PDU). The power system may reduce a number of AC-to-DC conversion steps, which reduces energy loss, heat generation, and design complexity.

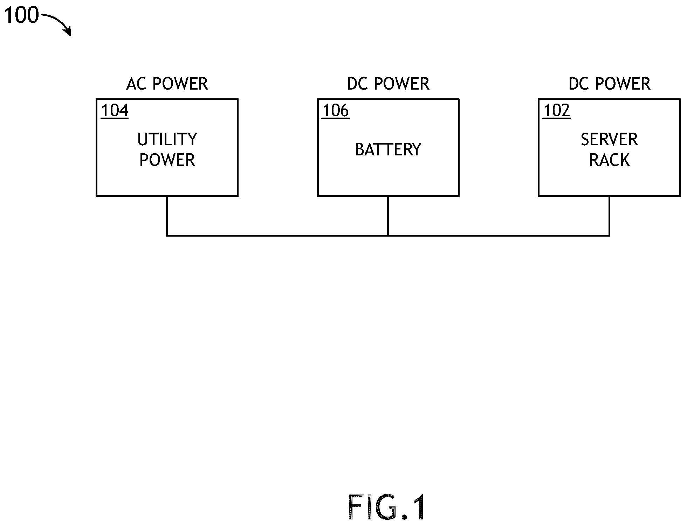

FIG. 1 illustrates a block diagram depicting a power system scheme 100 for powering a server rack 102 (e.g., a plurality of servers), in accordance with one or more embodiments of the disclosure. The power system scheme 100 includes receiving utility power 104 (e.g., an input AC voltage from an electric utility provider), converting the input AC voltage to output DC voltage, and storing the output DC power in a battery 106. The DC power is then transmitted to the server rack 102 for powering the plurality of servers. The power system scheme 100 does not include converting the DC voltage from the battery to AC voltage as the power is being distributed to the server rack 102. For example, the power system scheme 100 does not include distributing AC voltage through a PDU to power the server rack 102.

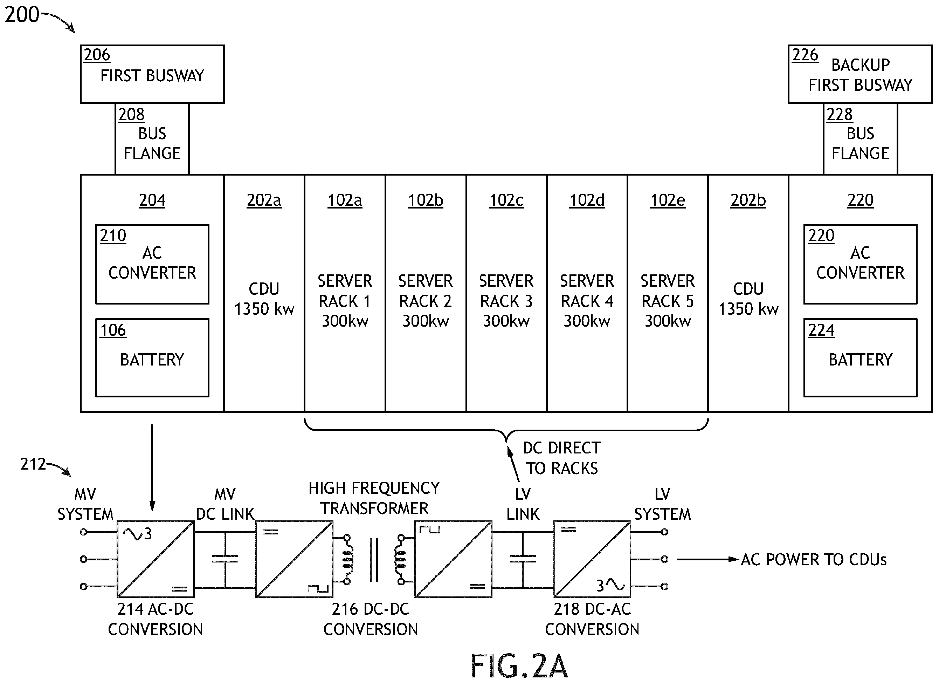

FIG. 2A illustrates a block diagram depicting a power system 200, in accordance with one or more embodiments of the disclosure. The power system 200 converts an input AC voltage to an output DC voltage that is consumed by one or more server racks 102a-d. The power system 200 may also power one or more cooling distribution units (CDU) 202a-b that cool the one or more server racks 102a-d.

In embodiments, the power system 200 includes a power center 204 that converts input AC voltage to an output DC voltage. The power center 204 includes a battery 106 that stores DC power and releases the output DC voltage, and an AC-to-DC conversion device (e.g., AC converter 210), such as a solid-state transformer that receives the input AC voltage from a first busway 206 (e.g., via a first busway flange 208) and converts the input AC voltage to either a secondary AC voltage or an output DC voltage.

Solid-state transformers can operate under different stages or modes of conversion including a DC-DC stage, an AC-DC stage, a DC-AC stage or an AC-DC-DC-AC mode. For example, the solid-state transformer may convert the input AC voltage into a secondary AC voltage, and then subsequently convert the secondary AC voltage into the output DC voltage. In another example, the solid-state transformer may convert the input AC voltage into a secondary AC voltage, and a separate rectifier or other conversion device converts the secondary AC voltage into the output DC voltage. In some embodiments, the initial AC voltage is converted into an intermediate DC voltage before further conversion to the output DC voltage. Other conversion devices (e.g., rectifiers, and transformers) may be used to convert the input AC voltage to the DC output voltage. Once the input AC voltage is converted to the output DC voltage, the output DC voltage may be transmitted directly to the server racks for consumption or to the battery 106 and stored until power by the server racks is needed.

In embodiments, the battery 106 is integrated within an uninterruptible power supply (UPS). The UPS may include any type of battery system. For example, the UPS may be configured as an online/double-conversion uninterruptible power supply, a single-conversion uninterruptible power supply, a multi-mode uninterruptible power supply, DC uninterruptible power supply, a line-interactive uninterruptible power supply, an offline/standby uninterruptible supply, a hybrid topology/double conversion on demand uninterruptible power supply, and a ferroresonant uninterruptible power supply. For instance, the power center 204 may include a UPS where the battery 106 receives power from the AC converter 210 as an output DC voltage. The battery 106 then releases the power as the output DC voltage to power the server racks 102a-d. In this manner, the UPS and battery 106 isolate DC power loads from raw utility power entirely, and outputs power that has been conditioned for critical equipment such as the server racks 102a-d.

Referring to FIG. 2A, a conversion scheme 212 for converting between the AC voltages and DC voltages is shown. For example, the conversion scheme 212 may include an AC-DC conversion step 214 that occurs in the power center 204, a DC-DC conversion step 216 that occurs either in the power center 204 or at another point within the power system 200 (e.g., at the one or more server racks 102a-d).

In embodiments, a portion of the output DC voltage is converted back to an AC voltage to power non-server devices, as shown in DC-AC conversion step 218. For example, the AC voltage may be used to power the CDUs 202a-b.

In embodiments, the power system 200 includes a backup power center 220. The backup power center 220 may be similar to the power center 204. For example, the backup power center 220 may include an AC converter 221 such as the solid-state transformer as described herein. The backup power center 220 is coupled to a backup first busway 226 via a backup first busway flange 228. The backup power center 220 provides power to the server racks 102a-d and/or CDUs 202a-b if the power center 204 or components associated with the power center 204 fails.

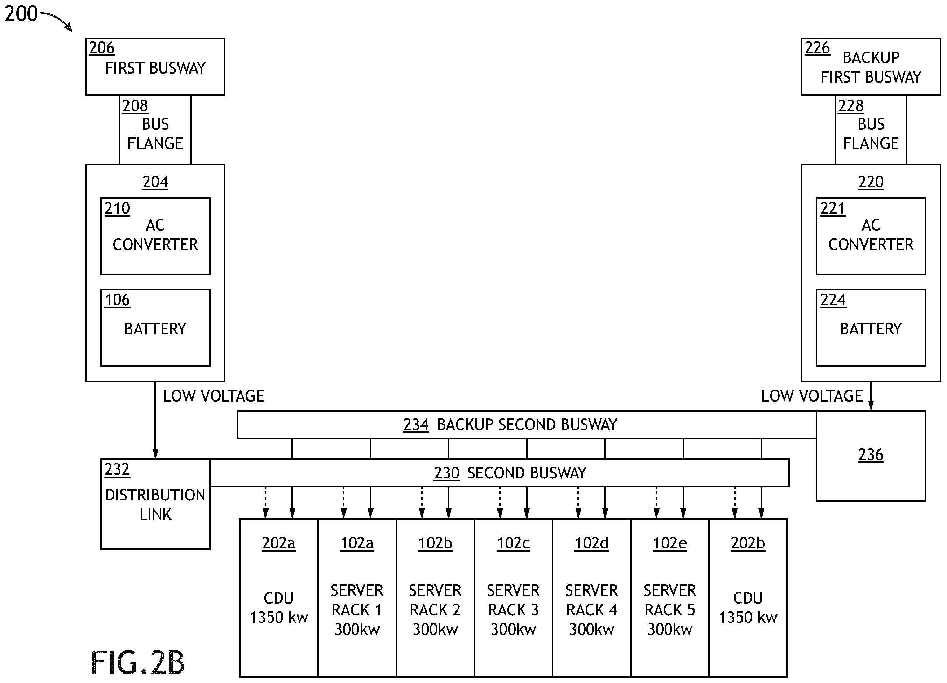

FIG. 2B illustrates a block diagram depicting a view of power system 200 that includes a second busway 230, in accordance with one or more embodiments of the disclosure. The second busway 230 enables the distribution of the output DC voltage to the one or more servers 102a-d and/or the CDUs 202a-b. For example, the power system 200 may include CDUs 102a-d that operate under DC power and are therefore operable via the output DC voltage. In another example, the power system 200 may include inverters at each CDU 202a-b that convert the DC output voltage to a consumption voltage for the CDUs 202a-b to use. The second busway may receive the output DC voltage from the power center 204 via a distribution link, such as a tap off box.

In embodiments, the power system 200 includes a backup second busway 234 that receives power from the backup power center 220 (e.g., via a backup distribution link 236 such as a tap off box). The backup second busway provides power to the server racks 102a-d and/or CDUs 202a-b if the second busway 230 fails to deliver power. In embodiments, the second busway 230 and/or backup second busway 234 are capable of delivering over 500 A, delivering over 1000 A, or delivering over 1500 A.

In embodiments, the power center 204 is configured to receive a medium input AC voltage. For example, the medium input AC voltage may be a voltage equal to and/or greater than 600 V. In another example, the medium input AC voltage may be greater than 1000 V (1 kV). In embodiments, the power center 204 may have an upper limit for voltage. For example, the medium input AC voltage may have an upper limit of 1kV, of 2.4 kV, of 5 kV, of 10 kV, of 20 kV, of 36 kV or of 69 kV. For instance, the power center 204 may operate with voltages within the range of 600 V to 69 kV. In another instance, the power center 204 may operate with voltages within the range of 2.4 kV to 69 kV.

In embodiments, the power center 204 may include one or more of the battery 106, the AC converter 210, the first busway flange 208, the first busway 206, the distribution link 232, or the second busway 230. In embodiments, the power system 200 may include one or more of the power center 204, the backup power center 220, the first busway 206, the backup first busway 226, the first busway flange 208, the backup first busway flange, the second busway 230, the backup second busway 234, the distribution link 232, the backup distribution link 236, the one or more server racks 102a-d (e.g., with the plurality of servers), and or the CDUs 202a-b.

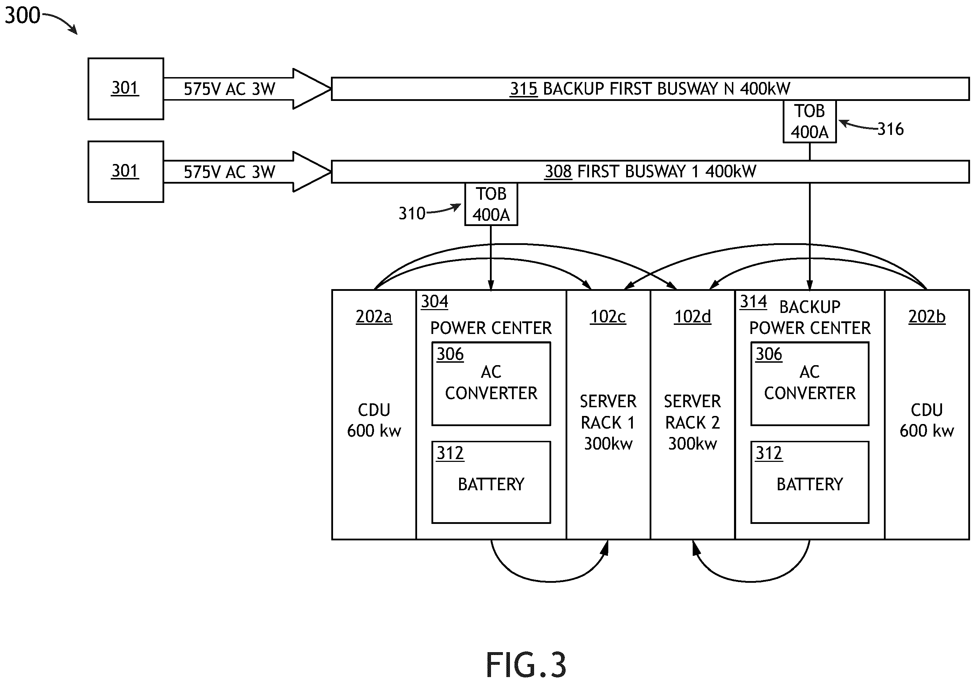

Referring to FIG. 3, in embodiments, another power system 300 is disclosed, in accordance with one or more embodiments of the disclosure. The power system 300 may include one or more components as described for power system 200, and vice versa. The power system 300 converts and distributes a low input AC voltage from a low voltage AC source 301 to one or more server racks 102a-b and/or CDUs 202a-b. A low input AC voltage may include an input AC voltage equal to or less than 600 V. For example, the low input AC voltage may be approximately 575 V.

In embodiments, the power system 300 includes a power center 304. The power center 302 may include one or more components of the power center 304, and vice versa. For example, the power center 304 may include an AC converter 306 for converting the incoming input AC voltage to an output DC voltage. For instance, the power center 304 may include a solid-state transformer that receives the input AC voltage from a first busway 308 (e.g., a low voltage (LV) first busway) via a tap off box 310, and converts the input AC voltage to either a secondary AC voltage or an output DC voltage. For example, the solid-state transformer may convert the input AC voltage into a secondary AC voltage, and then subsequently convert the secondary AC voltage into the output DC voltage. In another example, the solid-state transformer may convert the input AC voltage into a secondary AC voltage, and a separate rectifier or other conversion device converts the secondary AC voltage into the output DC voltage. In some embodiments, the initial AC voltage is converted into an intermediate DC voltage before further conversion to the output DC voltage. Other conversion devices (e.g., rectifiers, and transformers) may be used to convert the input AC voltage to the DC output voltage. Once the input AC voltage is converted to the output DC voltage, the output DC voltage may be transmitted directly to the server racks for consumption or to a battery 312 and stored until power by the server racks is needed.

The power system 300 may supply power to the CDUs 202a-b directly through the first busway (e.g., via an input AC voltage) or through the power center 304. For example, the power center 304 may provide an output DC voltage to CDUs 202a-b that is used directly by the CDUs 202a-b (e.g., for DC-compatible CDUs 202a-b) or is converted via an inverter to an AC voltage. In another example, the power center 304 may provide a stepped-down AC voltage for the CDUs 202a-b.

In embodiments, the power system 300 includes a backup power center 314 that receives power from a backup first busway 315 via a backup tap off box 316, the backup first busway electrically coupled to a backup low AC voltage source. The backup power center 314 provides power to the server racks 102a-b and/or CDUs 202a-b if the first busway fails to deliver power. In embodiments, the first busway 308 and/or backup first busway 315 are capable of delivering over 500 A, delivering over 1000 A, or delivering over 1500 A.

In embodiments, the power center 304 may include one or more of the battery 312, the AC converter 306, the first busway 308, or the first tap off box. In embodiments, the power system 300 may include one or more of the power center 304, the backup power center 314, the first busway 308, the backup first busway 315, the first tap off box 310, the backup first tap off box 316, the one or more server racks 102a-b (e.g., with the plurality of servers), and or the CDUs 202a-b.

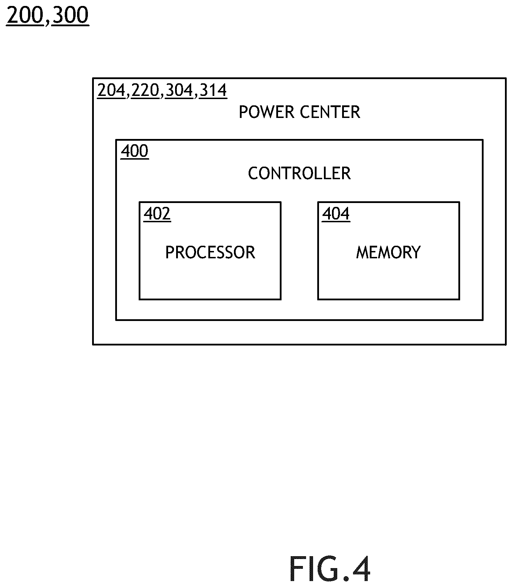

FIG. 4 illustrates a block diagram depicting the power systems 200, 300, in accordance with one or more embodiments of the present disclosure. The power systems 200, 300 may include one or more power centers 204, 304, and/or one or more backup power centers 220, 314.

In some embodiments, the one or more power centers 204, 304, and/or one or more backup power centers 220, 314 include controller 400. In some embodiments, the controller 400 includes one or more processors 402. For example, the one or more processors 402 may be configured to execute a set of program instructions maintained in a memory 404, or memory device. As an illustration, the controller 400 may be configured to execute commands for controlling the conversion of an input AC voltage into an output DC voltage by the one or more power centers 204, 304, and/or one or more backup power centers 220, 314. It is contemplated that the controller 400 may be operatively coupled with one or more sensors, such as one or more current sensors, which may be employed to determine an overcurrent event whereby the controller 400 may be configured to take one or more evasive actions, such as, opening a relay and the like.

The one or more processors 402 of the controller 400 may include any processor or processing element known in the art. For the purposes of the present disclosure, the term "processor" or "processing element" may be broadly defined to encompass any device having one or more processing or logic elements (e.g., one or more microprocessor devices, one or more application specific integrated circuit (ASIC) devices, one or more field programmable gate arrays (FPGAs), or one or more digital signal processors (DSPs)). In this sense, the one or more processors 402 may include any device configured to execute algorithms and/or instructions (e.g., program instructions stored in memory). In some embodiments, the one or more processors 402 may be embodied as a desktop computer, mainframe computer system, workstation, image computer, parallel processor, networked computer, or any other computer system configured to execute program instructions. Further, the steps described throughout the present disclosure may be carried out by a single controller or, alternatively, multiple controllers. Additionally, the controller 400 may include one or more controllers housed in a common housing or within multiple housings.

The memory 404 may include any storage medium known in the art suitable for storing program instructions executable by the associated one or more processors 402. For example, the memory 404 may include a non-transitory memory medium. By way of another example, the memory 404 may include, but is not limited to, a read-only memory (ROM), a random-access memory (RAM), a magnetic or optical memory device (e.g., disk), a magnetic tape, a solid-state drive and the like. It is further noted that the memory 404 may be housed in a common controller housing with the one or more processors 402. In some embodiments, the memory 404 may be located remotely with respect to the physical location of the one or more processors 402 and the controller 400. For instance, the one or more processors 402 of the controller 400 may access a remote memory (e.g., server), accessible through a network (e.g., internet or intranet).

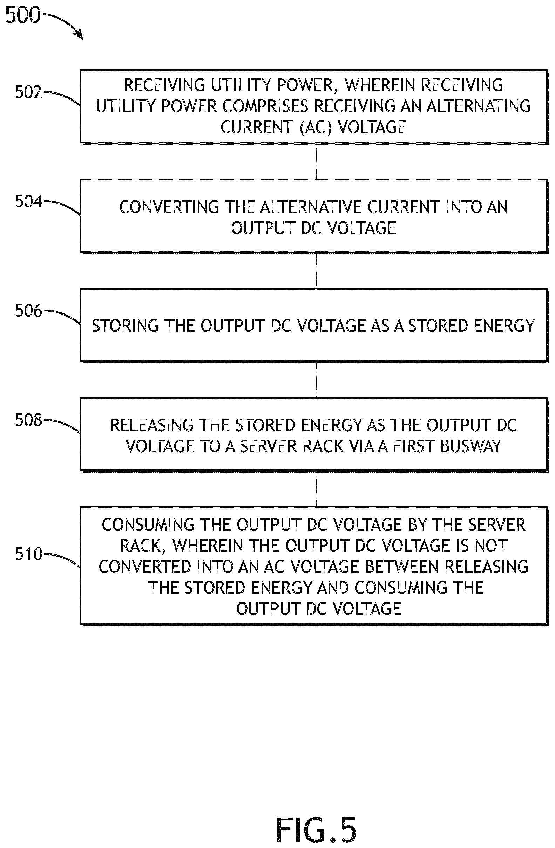

FIG. 5 illustrates a process flow diagram depicting a method 500 for powering a server rack, in accordance with one or more embodiments of the disclosure. The method 500 may be utilized by the power systems 200, 300 and power centers 204, 304 described herein.

In embodiments, the method 500 includes a step 502 of receiving utility power, wherein receiving utility power comprises receiving an input AC voltage. For example, the utility power may include a medium input AC voltage equal to or greater than 600 V, or a low input AC voltage equal to or less than 600 V.

In embodiments, the method 500 includes a step 504 of converting the input alternative current into an output DC voltage. For example, the input alternative current may be converted into an output DC voltage via a solid-state transformer or other rectifying device within the power center 204, 304.

In embodiments, the method 500 includes a step 506 of storing the output DC voltage as a stored energy. For example, the output DC voltage may be stored in a battery 106. The battery 106 may be a stand-alone battery, a battery 106 included within the power center 204, 304, and/or a battery 106 that is part of an uninterruptible power supply (UPS). The UPS include any type of battery system as described herein.

In embodiments, the method 500 includes a step 508 of releasing the stored energy as the output DC voltage to a server rack 102. For example, for the medium voltage power system 200, the stored energy may be released onto a second busway 230 electrically coupled to the server rack 102. In another example, for the low voltage power system 300, the power may be distributed directly to the server rack 102 via a busway or cable.

In embodiments, the method 500 includes a step 510 of consuming the output DC voltage by the server rack 102, wherein the output DC voltage is not converted into an AC voltage between releasing the stored energy and consuming the output DC voltage. For example, the output DC voltage leaving the battery 108 is not converted into an AC at any point between the output DC voltage leaving the battery 108 and the output DC voltage being consumed by the plurality of servers of the server racks 102. The output DC voltage may be adjusted (e.g., increased or decreased) as the DC power travels from battery 106 to server rack 102. Because DC power released from the battery 106 is not converted to AC power for transport to the server rack 102, and converted back into DC power for use by the plurality of servers, energy losses and heat increased due to DC-AC-DC conversion are reduced, as well as the complexity of the power system 200, 300.

The herein-described subject matter sometimes illustrates different components contained within or connected with different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

Those skilled in the art will recognize that it is common within the art to describe devices and/or processes in the fashion set forth herein, and thereafter use engineering practices to integrate such described devices and/or processes into power and/or data processing systems. That is, at least a portion of the devices and/or processes described herein can be integrated into a data processing system via a reasonable amount of experimentation. Those having skill in the art will recognize that a typical power and/or data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical power and/or data processing system may be implemented utilizing any suitable commercially available components, such as those typically found in power and/or data computing/communication and/or network computing/communication systems.

It is further contemplated that each of the embodiments of the method described above may include any other step(s) of any other method(s) described herein. In addition, each of the embodiments of the method described above may be performed by any of the systems described herein.

It will be understood by those within the art that, in general, terms used herein, and especially in the appended claims (e.g., bodies of the appended claims) are generally intended as "open" terms (e.g., the term "including" should be interpreted as "including but not limited to," the term "having" should be interpreted as "having at least," the term "includes" should be interpreted as "includes but is not limited to," etc.).

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the true spirit and scope of the subject matter described herein. Furthermore, it is to be understood that the invention is defined by the appended claims.
The disclosure comprises the following items:
1. A power system comprising:
   a power center configured to convert an input alternating current (AC) voltage to an output direct current (DC) voltage comprising:
   a busway flange configured to receive the input AC voltage from a first busway;
   an AC converter configured to receive the input AC voltage from the busway flange and convert the input AC voltage into the output DC voltage; and
   a battery configured to:
      to store DC power; and
      release the output DC voltage to a second busway.
2. The power system of item 1, wherein the input AC voltage is equal to or greater than 600 V.
3. The power system of item 1 or item 2, further comprising the second busway, wherein the second busway delivers the output DC voltage to a plurality of servers, wherein the plurality of servers are powered by the output DC voltage without an intermediate DC to AC conversion step.
4. The power system of any preceding item, wherein the AC converter comprises a solid-state transformer.
5. The power system of any preceding item, wherein the second busway delivers the output DC voltage to a cooling distribution unit.
6. The power system of any preceding item, wherein the cooling distribution unit is powered by the output DC voltage without an intermediate DC to AC conversion step.
7. The power system of any preceding item, wherein the output DC voltage is converted to an AC voltage to power the cooling distribution unit.
8. The power system of any preceding item, further comprising one or more tap of boxes electrically coupling the second busway to the plurality of servers.
9. The power system of any preceding item, further comprising a backup power center and a backup second busway electrically couplable to the plurality of servers, wherein the backup second busway supplies a backup output DC voltage to the plurality of servers if the second busway fails.
10. The power system of any preceding item, further comprising the plurality of servers.
11. A power system comprising:
   a power center configured to convert an input alternating current (AC) voltage to an output direct current (DC) voltage comprising:
   a tap off box configured to receive the input AC voltage from a first busway;
   an AC converter configured to receive the input AC voltage from the tap off box and convert the input AC voltage into the output DC voltage; and
   a battery configured to:
      to store the output DC voltage; and
      release an output DC voltage to a plurality of servers.
12. The power system of item 11, wherein the input AC voltage is equal to or less than 600 V.
13. The power system of item 11 or item 12, wherein the plurality servers are powered by the output DC voltage from the battery without an intermediate DC to AC conversion step.
14. The power system of any of items 11-13, wherein the AC converter comprises a solid-state transformer.
15. The power system of any of items 11-14, wherein the power center delivers power to a cooling distribution unit.
16. The power system of any of items 11-15, wherein the power comprises an AC voltage.
17. The power system of any of items 11-16, wherein the power comprises a DC voltage.
18. The power system of any of items 11-17, further comprising the first busway.
19. The power system of any of items 11-18, further comprising a backup power center electrically couplable to the plurality of servers, wherein the backup power center supplies a backup voltage to the plurality of servers of the power center fails.
20. A method for powering a server rack comprising:
   receiving utility power, wherein receiving the utility power comprises receiving an input alternating current (AC) voltage;
   converting the input AC voltage into an output DC voltage;
   storing the output DC voltage as a stored energy;
   releasing the stored energy as the output DC voltage to the server rack; and
   consuming the output DC voltage by the server rack, wherein the output DC voltage is not converted into an AC voltage between releasing the stored energy and consuming the output DC voltage.

## Claims

1. A power system comprising:
a power center configured to convert an input alternating current, AC, voltage to an output direct current, DC, voltage comprising:
a busway flange configured to receive the input AC voltage from a first busway;
an AC converter configured to receive the input AC voltage from the busway flange and convert the input AC voltage into the output DC voltage; and
a battery configured to:
store DC power; and
release the output DC voltage to a second busway.

2. The power system of claim 1, wherein the input AC voltage is equal to or greater than 600 V.

3. The power system of claim 1 or claim 2, further comprising the second busway, wherein the second busway is configured to deliver the output DC voltage to a plurality of servers, wherein the plurality of servers are powered by the output DC voltage without an intermediate DC to AC conversion step.

4. The power system of any preceding claim, wherein the AC converter comprises a solid-state transformer.

5. The power system of claim 3, wherein the second busway is configured to deliver the output DC voltage to a cooling distribution unit.

6. The power system of claim 5, wherein the cooling distribution unit is configured to be powered by the output DC voltage without an intermediate DC to AC conversion step.

7. The power system of claim 5, wherein the output DC voltage is converted to an AC voltage to power the cooling distribution unit.

8. The power system of any of claims 3, 5, 6 or 7, further comprising one or more tap off boxes electrically coupling the second busway to the plurality of servers.

9. The power system of any of claims 3, 5, 6, 7 or 8, further comprising a backup power center and a backup second busway electrically couplable to the plurality of servers, wherein the backup second busway is configured to supply a backup output DC voltage to the plurality of servers if the second busway fails.

10. The power system of any of claims 3, 5, 6, 7, 8 or 9, further comprising the plurality of servers.

11. A method for powering a server rack comprising:
receiving utility power, wherein receiving the utility power comprises receiving an input alternating current, AC, voltage;
converting the input AC voltage into an output DC voltage;
storing the output DC voltage as a stored energy;
releasing the stored energy as the output DC voltage to the server rack; and
consuming the output DC voltage by the server rack, wherein the output DC voltage is not converted into an AC voltage between releasing the stored energy and consuming the output DC voltage.
